# EUROPÄISCHE PATENTANMELDUNG

(11) **EP 4 693 770 A1**
(43) Veröffentlichungstag der Anmeldung: **11.02.2026**
(21) Anmeldenummer: 25191326.5
(22) Anmeldetag: 23.07.2025
(51) Int. Cl.: H01S 5/042, H01S 5/068, H01S 5/0683

(54) **VERFAHREN ZUM ÜBERWACHEN EINER LASERREGELUNG EINES LASER-SYSTEMS**

(30) Priorität: 07.08.2024 DE 102024207479
(71) Anmelder: Robert Bosch GmbH, 70442 Stuttgart (DE)
(72) Erfinder: Copeto, David, 71638 Ludwigsburg (DE); Noe, Stefan, 70563 Stuttgart (DE); Hoffarth, Joern, 72764 Reutlingen (DE)

(57) **Zusammenfassung**

Die Erfindung betrifft ein Verfahren (100) zum Überwachen einer Laserregelung eines Laser-Systems (1), umfassend die nachfolgenden Schritte:
- Durchführen (101) der Laserregelung des Laser-Systems (1) unter Verwendung eines ersten Analog-Digital-Wandlers (2),
- Überwachen (102) der Laserregelung des Laser-Systems (1) unter Verwendung eines zweiten Analog-Digital-Wandlers (3),
wobei der zweite Analog-Digital-Wandler (3) als eine Redundanz zu dem ersten Analog-Digital-Wandler (2) in dem Laser-System (1) ausgebildet ist. Ferner betrifft die Erfindung ein Computerprogramm, eine Vorrichtung sowie ein Speichermedium zu diesem Zweck.

## Beschreibung

Die Erfindung betrifft ein Verfahren zum Überwachen einer Laserregelung eines Laser-Systems. Ferner betrifft die Erfindung ein Computerprogramm, eine Vorrichtung sowie ein Speichermedium zu diesem Zweck.

### Stand der Technik

Analog-Digital-Wandler (AD-Wandler) spielen eine wesentliche Rolle in der Steuerung von Laser-Systemen, indem sie analoge Signale in digitale Daten umwandeln, die für die präzise Regelung und Steuerung des Lasers erforderlich sind. Diese Wandler sind entscheidend für die Erfassung und Verarbeitung von Signalen, die die Leistung, Stabilität und Genauigkeit des Lasers beeinflussen.

Laser-Systeme werden in einer Vielzahl von Anwendungen eingesetzt, beispielsweise zur Entfernungsmessung. Eine zuverlässige und genaue Steuerung des Lasers ist in diesen Anwendungen von großer Bedeutung. Die Qualität der von den AD-Wandlern gelieferten Daten hat direkten Einfluss auf die Steuerungsmechanismen des Lasers, einschließlich einer Leistungsregelung.

Ein Ausfall oder Fehler in einem AD-Wandler kann schwerwiegende Folgen für die Leistung und Sicherheit des Laser-Systems haben. Beispielsweise kann ein defekter AD-Wandler zu falschen Steuerungsbefehlen führen, was eine unkontrollierte Änderung der Laserleistung oder -richtung zur Folge haben kann. Dies kann nicht nur die Qualität der ausgeführten Arbeit beeinträchtigen, sondern auch potenziell gefährliche Situationen verursachen, insbesondere in medizinischen oder industriellen Umgebungen. Darüber hinaus können Fehler in der Signalverarbeitung durch AD-Wandler zu einer erheblichen Beeinträchtigung der Systemzuverlässigkeit und -effizienz führen, was hohe Kosten für Reparaturen und Ausfallzeiten nach sich ziehen kann.

Daher ist die Entwicklung robuster und hochpräziser AD-Wandler von zentraler Bedeutung, um die zuverlässige und sichere Funktion von Laser-Systemen zu gewährleisten.

### Offenbarung der Erfindung

Gegenstand der Erfindung ist ein Verfahren mit den Merkmalen des Anspruchs 1, ein Computerprogramm mit den Merkmalen des Anspruchs 7, eine Vorrichtung mit den Merkmalen des Anspruchs 8, ein computerlesbares Speichermedium mit den Merkmalen des Anspruchs 9 sowie ein Laser-System mit den Merkmalen des Anspruchs 10. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Computerprogramm, der erfindungsgemäßen Vorrichtung, dem erfindungsgemäßen computerlesbaren Speichermedium sowie dem erfindungsgemäßen Laser-System, und jeweils umgekehrt, so dass bezüglich der Offenbarung der Erfindung stets auch eine wechselseitige Bezugnahme möglich ist.

Gegenstand der Erfindung ist insbesondere ein Verfahren zum Überwachen einer Laserregelung eines Laser-Systems, umfassend die nachfolgenden Schritte, wobei die Schritte wiederholt und/oder nacheinander durchgeführt werden können. Das Laser-System ist insbesondere ein Laser-Entfernungsmessgerät. Die Laserregelung bezieht sich insbesondere auf eine Regelung einer Laserleistung eines Lasers des Laser-Systems. Diese kann beispielsweise in Abhängigkeit von einem Diodenstrom einer Laserdiode des Lasers variieren.

In einem ersten Schritt wird vorzugsweise die Laserregelung des Laser-Systems unter Verwendung eines ersten Analog-Digital-Wandlers durchgeführt. Dabei wird insbesondere ein Laser in dem Laser-System, beispielsweise hinsichtlich einer Laserleistung, geregelt. Um die Laserregelung des Lasers in dem Laser-System unter Verwendung des Analog-Digital-Wandlers durchzuführen, kann folgender Prozess angewendet werden: Ein Laserstrom des Lasers kann durch eine Regelungsschleife gesteuert werden, insbesondere unter Verwendung eines Messreglers. Der Analog-Digital-Wandler kann das analoge Signal des Laserstroms in ein digitales Signal umwandeln, das von einem Mikrocontroller verarbeitet werden kann. Der Mikrocontroller kann das digitale Signal des Laserstroms mit einem Referenzsignal vergleichen und den Laserstrom entsprechend anpassen, um eine stabile Ausgangsleistung des Lasers zu gewährleisten. Die Regelungsschleife kann auch auf andere Parameter des Laser-Systems angewendet werden, wie z.B. eine Temperatur, um eine optimale Leistung und Stabilität des Lasers zu gewährleisten.

In einem weiteren Schritt wird vorzugsweise die Laserregelung des Laser-Systems unter Verwendung eines zweiten Analog-Digital-Wandlers überwacht, wobei der zweite Analog-Digital-Wandler als eine Redundanz zu dem ersten Analog-Digital-Wandler in dem Laser-System ausgebildet ist. Das Überwachen der Laserregelung kann beispielsweise auf Basis eines Vergleiches von jeweiligen Ausgabewerten der Analog-Digital-Wandler erfolgen. Das Überwachen kann beispielsweise auf Basis einer Analyse von Daten eines Serial Peripheral Interface (SPI)-Kommunikationskanals durchgeführt werden. Dafür weisen vorzugsweise beide Analog-Digital-Wandler eine entsprechende Schnittstelle auf und kommunizieren über denselben SPl-Kommunikationskanal. So kann vorteilhaft festgestellt werden, wenn der erste Analog-Digital-Wandler fehlerhafte Ausgabewerte ausgibt, was zu einer fehlerhaften Ansteuerung eines Lasers des Laser-Systems führen kann. Dadurch, dass über den Kommunikationskanal lediglich die Kontrolle nicht aber die Regelung vorgenommen wird, wird vorteilhaft insbesondere auch bei einem Fehlerfall im Kommunikationskanal die Laserleistung weiterhin stabil gehalten.

Durch das Verfahren gemäß der Erfindung kann das Laser-System vorteilhaft redundant überwacht werden. Ein Ausfall des ersten Analog-Digital-Wandlers kann vorteilhaft durch den zweiten Analog-Digital-Wandler erkannt und gegebenenfalls kompensiert werden. Demnach kann das Verfahren ferner den Schritt umfassen, dass der zweite Analog-Digital-Wandler im Falle eines Fehlers des ersten Analog-Digital-Wandlers eine Funktion des ersten Analog-Digital-Wandlers übernimmt.

Optional kann es vorgesehen sein, dass der zweite Analog-Digital-Wandler eine andere Zeitbasis hinsichtlich einer Abtastrate als der erste Analog-Digital-Wandler verwendet. Beispielsweise könnte der zweite Analog-Digital-Wandler doppelt so häufig oder auch nur halb so häufig abtasten wie der erste Analog-Digital-Wandler. Damit kann der erste Analog-Digital-Wandler beispielsweise die Spitzenleistung des Lasers abtasten, während der zweite Analog-Digital-Wandler die mittlere Laserleistung erfassen kann. Die mittlere Laserleistung kann beispielsweise entscheidend zur Einhaltung einer gesetzlichen Norm sein. Das schnellere Abtasten, hilft beispielsweise einem schnelleren Regeln und/oder Hochfahren des Lasers.

Vorteilhafterweise kann im Rahmen der Erfindung vorgesehen sein, dass der zweite Analog-Digital-Wandler eine andere Filterung als der erste Analog-Digital-Wandler verwendet. Die Filterung könnte dabei bei dem zweiten Analog-Digital-Wandler andere Konfigurationsparameter aufweisen wie beispielsweise eine andere Filterbandbreite. Auch ist denkbar, dass im einen Analog-Digital-Wandler eine Tiefpassfilterung und in dem anderen Analog-Digital-Wandler eine Bandpassfilterung vorgesehen ist.

Es kann optional möglich sein, dass der zweite Analog-Digital-Wandler ein anderes Messverfahren als der erste Analog-Digital-Wandler verwendet. Beispielsweise kann der erste Analog-Digital-Wandler ein Sigma-Delta-Wandler sein und der zweite Analog-Digital-Wandler ein sukzessives Approximationsregister (SAR). Zusätzlich kann vorgesehen sein, dass der erste und der zweite Analog-Digital-Wandler nicht an dieselbe Versorgungsspannung, Referenzspannung und/oder Systemtakt angebunden sind. Durch den unterschiedlichen Aufbau und Einbindung können sich Fehler vorteilhaft nicht gleichzeitig auf beide Analog-Digital-Wandler auswirken.

Es kann im Rahmen der Erfindung vorgesehen sein, dass das Überwachen der Laserregelung ein Überwachen einer Stromversorgung des ersten und zweiten Analog-Digital-Wandlers umfasst. Dafür kann beispielsweise eine interne Spannungsreferenzquelle abgetastet werden, mit der beide Analog-Digital-Wandler verbunden sind. Auf diese Weise ist es möglich, dass die Integrität der Stromversorgung für beide Analog-Digital-Wandler überwacht wird. Mögliche Fehler in der Stromversorgung können dadurch frühzeitig erkannt und gegebenenfalls durch einen Mikrocontroller des Laser-Systems korrigiert werden, beispielsweise auch durch ein Abschalten.

Ebenfalls Gegenstand der Erfindung ist ein Laser-System, insbesondere Laser-Entfernungsmessgerät, umfassend einen Laser, einen Messregler und eine anwendungsspezifische integrierte Schaltung. Die anwendungsspezifische integrierte Schaltung umfasst insbesondere einen ersten und einen zweiten Analog-Digital-Wandler. Der erste und der zweite Analog-Digital-Wandler sind vorzugsweise physisch getrennt voneinander angeordnet und teilen sich eine selbe Stromversorgung und einen selben Quarz als Taktgeber. Das Laser-System ist insbesondere ausgebildet, um das Verfahren gemäß der Erfindung auszuführen.

Ebenfalls Gegenstand der Erfindung ist ein Computerprogramm, insbesondere Computerprogrammprodukt, umfassend Befehle, die bei der Ausführung des Computerprogrammes durch einen Computer diesen veranlassen, das erfindungsgemäße Verfahren auszuführen. Damit bringt das erfindungsgemäße Computerprogramm die gleichen Vorteile mit sich, wie sie ausführlich mit Bezug auf ein erfindungsgemäßes Verfahren beschrieben worden sind.

Ebenfalls Gegenstand der Erfindung ist eine Vorrichtung zur Datenverarbeitung, die eingerichtet ist, das erfindungsgemäße Verfahren auszuführen. Als die Vorrichtung kann bspw. ein Computer vorgesehen sein, welcher das erfindungsgemäße Computerprogramm ausführt. Der Computer kann wenigstens einen Prozessor zur Ausführung des Computerprogramms aufweisen. Auch kann ein nicht-flüchtiger Datenspeicher vorgesehen sein, in welchem das Computerprogramm hinterlegt und von welchem das Computerprogramm durch den Prozessor zur Ausführung ausgelesen werden kann.

Ebenfalls Gegenstand der Erfindung kann ein computerlesbares Speichermedium sein, welches das erfindungsgemäße Computerprogramm aufweist und/oder Befehle umfasst, die bei der Ausführung durch einen Computer diesen veranlassen, das erfindungsgemäße Verfahren auszuführen. Das Speichermedium ist bspw. als ein Datenspeicher wie eine Festplatte und/oder ein nicht-flüchtiger Speicher und/oder eine Speicherkarte ausgebildet. Das Speichermedium kann z. B. in den Computer integriert sein.

Darüber hinaus kann das erfindungsgemäße Verfahren auch als ein computerimplementiertes Verfahren ausgeführt sein. Alternativ oder zusätzlich kann zumindest einer der offenbarten Verfahrensschritte computer-implementiert sein und/oder automatisiert durchgeführt werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine schematische Visualisierung eines Verfahrens, einer Vorrichtung, eines Speichermediums sowie eines Computerprogramms gemäß Ausführungsbeispielen der Erfindung,
- Fig. 2: eine schematische Darstellung eines Laser-Systems gemäß Ausführungsbeispielen der Erfindung.

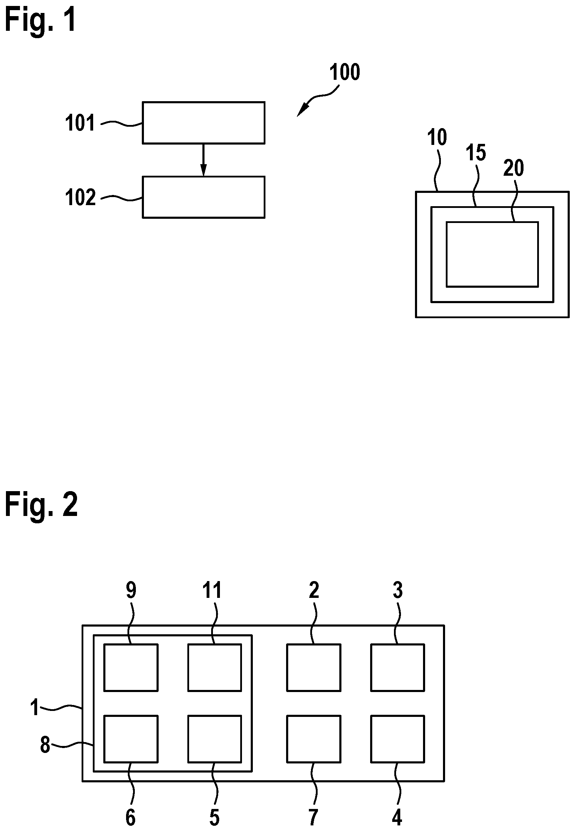

In Fig. 1 sind ein Verfahren 100, eine Vorrichtung 10, ein Speichermedium 15 sowie ein Computerprogramm 20 gemäß Ausführungsbeispielen der Erfindung schematisch dargestellt.

Fig. 1 zeigt insbesondere ein Ausführungsbeispiel eines Verfahrens 100 zum Überwachen einer Laserregelung eines Laser-Systems 1. In einem ersten Schritt 101 wird die Laserregelung des Laser-Systems 1 unter Verwendung eines ersten Analog-Digital-Wandlers 2 durchgeführt. In einem zweiten Schritt 102 wird die Laserregelung des Laser-Systems 1 unter Verwendung eines zweiten Analog-Digital-Wandlers 3 überwacht. Der zweite Analog-Digital-Wandler 3 ist dabei als eine Redundanz zu dem ersten Analog-Digital-Wandler 2 in dem Laser-System 1 ausgebildet.

Das Verfahren der vorliegenden Erfindung betrifft ein Laser-System 1 und gemäß Ausführungsbeispielen insbesondere ein Laser-Entfernungsmessgerät, das die indirekte Time of Flight (iToF)-Messung verwendet. Für dieses Ausführungsbeispiel sei auf Fig. 2 verwiesen. Dieses Laser-Entfernungsmessgerät 1 arbeitet beispielsweise mit einer Messung einer Phasenverschiebung eines modulierten Lichtsignals, das vom Laser-Entfernungsmessgerät ausgesendet und von einem Zielobjekt reflektiert wird. Im Folgenden wird die Funktionsweise der indirekten Time of Flight (iToF)-Messung beschrieben. Zunächst kann ein Laser 3, insbesondere eine Laserdiode des Lasers 3, im Laser-Entfernungsmessgerät 1 intensitätsmoduliertes Licht, beispielsweise im infraroten oder sichtbaren Bereich, in Richtung eines Zielobjekts senden. Die Modulation erfolgt insbesondere mit einer sinusförmigen oder Rechteckwelle. Das intensitätsmodulierte Licht trifft anschließend auf das Zielobjekt und wird zurück zum Laser-Entfernungsmessgerät 1 reflektiert. Ein Detektor 4 im Messgerät kann nun das reflektierte Licht empfangen. Da das Licht eine gewisse Zeit benötigt, um die Strecke hin und zurück zu legen, kommt es zu einer Phasenverschiebung zwischen dem ausgesendeten und dem empfangenen Signal. Diese Phasenverschiebung zwischen dem ausgesendeten und dem empfangenen Signal kann anschließend gemessen werden. Diese Phasenverschiebung ist insbesondere proportional zur zurückgelegten Entfernung des Lichts. Die Entfernung kann anschließend aus der Phasenverschiebung unter Berücksichtigung der Wellenlänge der Modulation und der Lichtgeschwindigkeit berechnet werden. Hierbei kann ferner vorgesehen sein, dass eine Referenzphase mit einem zweiten Detektor mit einem konstanten Abstand bestimmt wird (nicht dargestellt), um die Phasenverschiebung auf Basis eines Vergleiches mit der Referenzphase zu bestimmen.

Das Laser-Entfernungsmessgerät 1 kann einen Messregler 2 aufweisen. Der Messregler 2 übernimmt insbesondere eine Steuerung des Lasers 3.

So kann der Messregler 2 eine Emission des Lasers 3 steuern, indem er ein Ein- und Ausschalten sowie eine Intensität eines Laserstrahls des Lasers 3 regelt.

Dadurch kann sichergestellt werden, dass der Laserstrahl mit der richtigen Leistung und den richtigen Eigenschaften ausgesendet wird.

Ferner kann ein Laserstrahl des Laser-Systems 1 moduliert werden, beispielsweise in Form von gepulstem Licht und/oder einer kontinuierlichen Welle mit variabler Modulationsfrequenz. Nach dem Empfang des reflektierten Laserstrahls durch den Detektor 4 kann der Messregler 2 das empfangene Signal verarbeiten. Dies umfasst beispielsweise eine Verstärkung, Filterung und Umwandlung des empfangenen analogen Signals in ein digitales Signal zur weiteren Analyse, insbesondere durch einen Analog-Digital-Wandler 5. Ferner kann die Phasenverschiebung zwischen dem ausgesendeten und dem empfangenen Signal messen und gegebenenfalls mit der Referenzphase verglichen werden. Gemäß Ausführungsbeispielen umfasst das Laser-System 1 ferner vorzugsweise einen zweiten Analog-Digital-Wandler 6, der redundant zu dem ersten Analog-Digital-Wandler 5 geschaltet ist.

Der Messregler 2 kann ferner regelmäßig Kalibrierungen durchführen, um sicherzustellen, dass die Messungen präzise sind. Dafür kann er einen Zustand des Lasers 3 und des Detektors 4 überwachen, um sicherzustellen, dass diese ordnungsgemäß funktionieren.

Zudem kann das Laser-System 1, insbesondere das Laser-Entfernungsmessgerät, einen ersten und einen zweiten Analog-Digital-Wandler 5, 6 aufweisen. Die jeweiligen Analog-Digital-Wandler 5 wandeln vorzugsweise analoge Signale, die vom Detektor 4 empfangen werden, in digitale Signale um. Diese Signale repräsentieren insbesondere eine Lichtintensität, die vom Laser 3 ausgesendet wird. Die digitale Umwandlung kann es ermöglichen, die Phasenverschiebung zwischen dem ausgesendeten und dem empfangenen Signal zu analysieren. Die digitalen Signale, die von dem jeweiligen Analog-Digital-Wandler 5 bereitgestellt werden, können weiter gefiltert, verstärkt und verarbeitet werden, um Rauschen zu reduzieren und die Signalqualität zu verbessern.

Mit dem Verfahren gemäß Ausführungsbeispielen kann vorteilhaft eine Peripherie der Analog-Digital-Wandler 5,6 in einem Microcontroller 7 des Laser-Systems 1 und eine weitere elektrische Verbindung zum Microcontroller 7 entfallen.

Durch den physisch getrennten zweiten Analog-Digital-Wandler 6 in der anwendungsspezifischen integrierten Schaltung 8 (englisch: "application specific integrated circuit", ASIC) des Laser-Systems 1 und den selbständig laufenden Messregler 2 kann ein Standard-SPI-Kommunikationskanal zur Überwachung des Messreglers 2 genutzt werden. Beide Analog-Digital-Wandler 5,6 teilen sich die gleiche Stromversorgung 9 und den Quarz 11 als Taktgeber. Daher ist eine Überwachung der Stromversorgung 9 und das Überprüfen, dass die anwendungsspezifische integrierte Schaltung 8 reagiert, notwendig. Zum Überwachen der Stromversorgung 9 kann eine interne Spannungsreferenzquelle abgetastet werden. Neben dem Abschalten des Laser-Systems 1 über SPI kann der Microcontroller 7, wenn die anwendungsspezifische integrierte Schaltung 8 fehlerhaft ist, über einen Halbleiterschalter den Stromfluss nochmal separat stoppen.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

## Patentansprüche

1. Verfahren (100) zum Überwachen einer Laserregelung eines Laser-Systems (1), umfassend die nachfolgenden Schritte:
- Durchführen (101) der Laserregelung des Laser-Systems (1) unter Verwendung eines ersten Analog-Digital-Wandlers (5),
- Überwachen (102) der Laserregelung des Laser-Systems (1) unter Verwendung eines zweiten Analog-Digital-Wandlers (6),
wobei der zweite Analog-Digital-Wandler (6) als eine Redundanz zu dem ersten Analog-Digital-Wandler (5) in dem Laser-System (1) ausgebildet ist.

2. Verfahren (100) nach Anspruch 1,
**dadurch gekennzeichnet,**
**dass** der zweite Analog-Digital-Wandler (6) eine andere Zeitbasis hinsichtlich einer Abtastrate als der erste Analog-Digital-Wandler (5) verwendet.

3. Verfahren (100) nach einem der vorhergehenden Ansprüche,
**dadurch gekennzeichnet,**
**dass** der zweite Analog-Digital-Wandler (6) eine andere Filterung als der erste Analog-Digital-Wandler (5) verwendet.

4. Verfahren (100) nach einem der vorhergehenden Ansprüche,
**dadurch gekennzeichnet,**
**dass** der zweite Analog-Digital-Wandler (6) ein anderes Messverfahren als der erste Analog-Digital-Wandler (5) verwendet.

5. Verfahren (100) nach einem der vorhergehenden Ansprüche,
**dadurch gekennzeichnet,**
**dass** das Überwachen (102) der Laserregelung ein Überwachen einer Stromversorgung des ersten und zweiten Analog-Digital-Wandlers (5,6) umfasst.

6. Verfahren (100) nach einem der vorhergehenden Ansprüche,
**dadurch gekennzeichnet,**
**dass** das Überwachen (102) auf Basis einer Analyse von Daten eines Serial Peripheral Interface-Kommunikationskanals durchgeführt wird.

7. Computerprogramm (20), umfassend Befehle, die bei der Ausführung des Computerprogramms (20) durch einen Computer (10) diesen veranlassen, das Verfahren (100) nach einem der vorhergehenden Ansprüche auszuführen.

8. Vorrichtung (10) zur Datenverarbeitung, die eingerichtet ist, das Verfahren (100) nach einem der Ansprüche 1 bis 6 auszuführen.

9. Computerlesbares Speichermedium (15), umfassend Befehle, die bei der Ausführung durch einen Computer (10) diesen veranlassen, die Schritte des Verfahrens (100) nach einem der Ansprüche 1 bis 6 auszuführen.

10. Laser-System (1), umfassend einen Laser (4), einen Messregler (2) und eine anwendungsspezifische integrierte Schaltung (8),
wobei die anwendungsspezifische integrierte Schaltung (8) einen ersten und einen zweiten Analog-Digital-Wandler (5,6) umfasst,
wobei der erste und der zweite Analog-Digital-Wandler (5,6) physisch getrennt voneinander angeordnet sind und sich eine selbe Stromversorgung (9) und einen selben Quarz (11) als Taktgeber teilen, wobei das Laser-System (1) ausgebildet ist, um das Verfahren (100) nach einem der Ansprüche 1 bis 6 auszuführen.
